# EUROPEAN PATENT APPLICATION

(11) **EP 1 217 090 A1**
(43) Date of publication of application: **26.06.2002**
(21) Application number: 01310228.0
(22) Date of filing: 06.12.2001
(51) Int. Cl.: C23C 14/04, F01D 5/00

(54) **Vapor deposition repair of superalloy articles**

(30) Priority: 19.12.2000 US 741133
(71) Applicant: UNITED TECHNOLOGIES CORPORATION, Hartford, CT 06101 (US)
(72) Inventor: Neal, James Wesley, Kiev 03150 (UA); Belyavin, Alexander Fedorovich, Kiev 04211 (UA); Barnhart, Richard Roman, Germantown, TN 38139 (US)
(74) Representative: Leckey, David Herbert

(57) **Abstract**

A repair process for superalloy articles is described. Worn or cracked or otherwise defective areas at the surface of a superalloy component are repaired using vapor deposition to apply a repair filler material (70) to the defect (31).

## Description

The present invention relates to the repair of superalloy articles such as gas turbine engine components, using physical vapor deposition techniques.

Superalloys are widely used in gas turbine engines and in other applications where strength and ductility are required at elevated temperatures. As used herein, the term superalloy will include high temperature alloys based on Ni, Co, Fe or Ti. Ni base superalloys are most commonly used and have a microstructure consisting of a Ni solid solution (gamma phase) matrix containing a strengthening dispersion of gamma prime (Ni₃ Al, Ti) phase particles. Superalloys may be functionally defined in terms of their strength at elevated temperatures. For Ni, Co and Fe base superalloys, ultimate tensile strengths at 1,000°F (528°C) will exceed 90, 60 and 90 KSI, respectively (63.3 Kg/mm, 42.2 Kg/mm, and 63.3 Kg/mm respectively). Ti base superalloys will have an ultimate tensile strength in excess of 90 KSI (63.3 Kg/mm) at 600°F (316°C).

Superalloys are commonly formed by casting and forging. Cast superalloy articles may have equiaxed, columnar grain or single crystal microstructures. Superalloy components will have a grain size in excess of .1 mm and most often in excess of 1 mm.

Superalloy articles are costly and accordingly there is a desire to repair such articles when they become worn or damaged in service. Superalloy articles may also require repairs when mismanufactured or damaged before being put into service. In the past, such repairs have been made using brazing techniques. See, for example, U.S. Patent 5,320,690. Similar types of repairs have been made using welding techniques. See, for example, U.S. Patent 5,897,801 and EP 0,492,740. A somewhat different approach known as transient liquid phase repair has also been employed, as described, in U.S. Patents 4,008,844 and 5,806,751. A combination of transient liquid phase and plasma spraying is shown in U.S. 4,705,203. These prior techniques have not been entirely satisfactory because they all involve melting and uncontrolled solidification of superalloys. Most superalloys are prone to cracking during solidification. Some prior techniques also require the use of melting point depressants, such as B and Si, which can weaken the repaired area.

Electron beam physical vapor deposition is a technology which is practiced in the application of protective coatings to gas turbine components and is described, for example, in U.S. Patent 4,153,005.

The present invention relates to a method for repairing superalloy articles which have been worn or damaged in service, and may also be applied to newly manufactured articles that have defects. The invention process was developed for repair of gas turbine components, but is not so limited.

The damaged area is cleaned and a superalloy repair material is deposited by physical vapor deposition performed to fill the defect or damaged area. The undamaged area is usually provided with a mask so that the vapor deposited material is applied only to the damaged or defective area.

After the vapor deposited superalloy repair material is applied to an adequate thickness, the vapor deposited material is contoured to closely match the original contour of the superalloy article.

Figure 1 is a schematic drawing showing a gas turbine engine blade.

Figure 2 is a schematic drawing showing a gas turbine engine vane.

Figure 3 is an airfoil portion of a gas turbine engine component.

Figure 3a is a partial view of a defect in the airfoil shown in Figure 3.

Figure 4 is a schematic of the invention vapor deposition repair process.

Figures 5a and 5b show the article immediately after the vapor deposition process.

Figures 6a and 6b show the subsequent contour of the article during the final steps of the invention process.

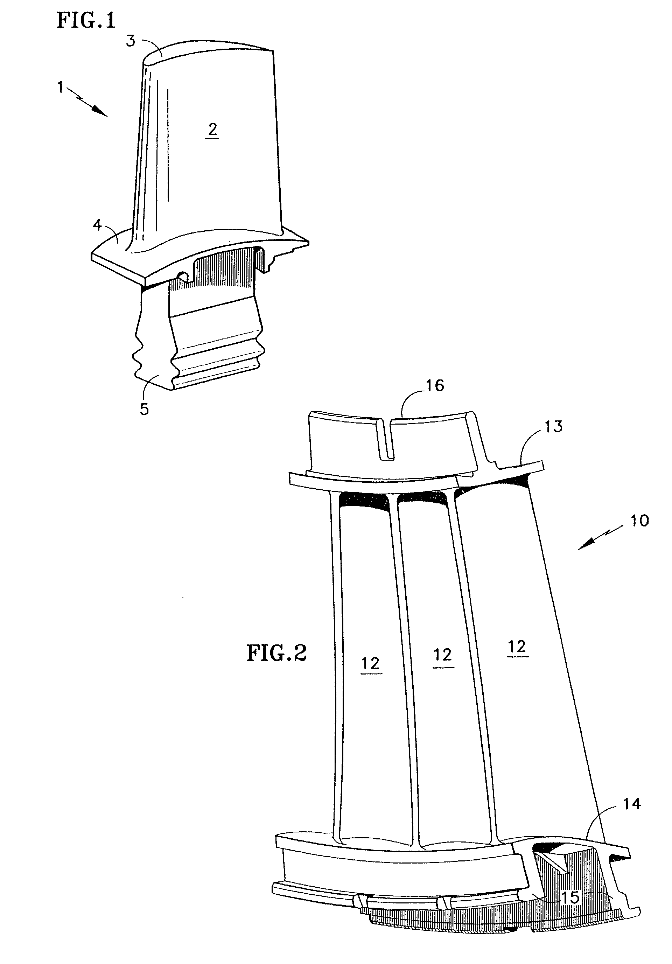

The present invention will be explained with reference to the figures. Figure 1 is a generalized drawing of a gas turbine blade. The turbine blade 1 includes an airfoil portion 2, a tip portion 3, a platform portion 4 and an attachment or root portion 5.

Figure 2 shows a generalized gas turbine vane 10 which includes airfoil portion 12, upper platform or shroud portion 13, platform portion 14, platform attachment means 15 and shroud attachment means 16.

In engine operation, these components, and particularly the airfoil portions and the shroud and platform surfaces which adjoin the airfoil portion (and which define the gas path), are exposed to hot gases and, after extended service, these surfaces can become worn or damaged. Wear or damage can occur gradually by erosion, or can be caused by foreign object damage or by cracking. Damage can be localized or more extensive, for example the entire leading edge of an airfoil may be eroded. Occasionally newly manufactured blades have surface defects, or are mismachined so that they have undersized areas. These blades may also be repaired using the invention process. Hereinafter, although the description may refer to damage occurring in service, it will be understood to include preservice damage.

It should be noted that damage to gas turbine superalloy components has several deleterious results. Specifically, the part is weakened, although parts are designed with safety factors. A more subtle problem is that the aerodynamic contour of the airfoil is altered, leading to reduced engine efficiency.

This invention relates to a method for repairing such service-related damage and will be illustrated with reference to an airfoil surface, however it will be understood that damage to platform and shroud surfaces can be repaired by the same method.

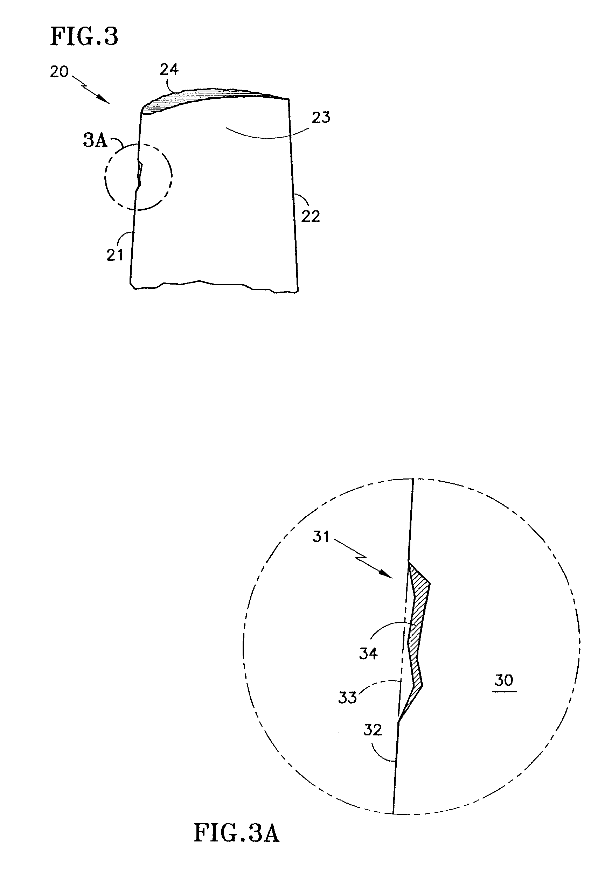

Figure 3 is a section of a blade or vane airfoil as shown in Figures 1 or 2 where the airfoil 20 includes a leading edge 21, a trailing edge 22, a concave or pressure surface 23, and a convex or suction surface 24. The leading and trailing edges are particularly susceptible to damage.

Figure 3a illustrates damage to the leading edge 21, the leading edge is shown as having a contour 32 which is interrupted by damage 31, phantom line 33 shows the original surface contour. Erosion damage 31 is shown as containing contamination 34. Fig. 3a will be understood to exemplify damage to any superalloy surface, including localized and generalized damage such as large scale erosion damage.

The object of the invention is to build up and repair the damage 31.

The damaged area will generally have a contaminated surface which may include oxides, dirt, products of combustion and the like. Prior to the vapor deposition of a superalloy repair material onto a damaged area, according to the present invention, the damaged surfaces should be cleaned, particularly if the blade has been used in an engine. It is also possible that there will be some change in the metallurgical structure and/or composition of the damaged surface immediately adjacent to the surface. Such changes may have resulted, for example, from oxidation which can reduce the aluminum content near the surface. Cleaning is performed in such a fashion that all surface contamination is removed and so that metallurgically impaired regions adjacent to the surface are removed to expose clean undamaged substrate material.

Cleaning methods include mechanical treatments, chemical treatments, electrochemical treatments, and electron discharge treatments. Mechanical cleaning methods include machining and grit blasting. Chemical treatments include treatments with acid or caustic chemicals. Caustic chemicals include materials such as sodium hydroxide and potassium hydroxide, which are effective in removing oxides, see for example U.S. patent 5,685,971. Chemical methods also include the use of halogen-containing gases, such as hydrogen fluoride and the complex gases which are produced by the decomposition of halogenated compounds such as PTFE (Teflon). Electrochemical treatments, known as ECM, and arc discharge treatments, known as EDM, are also known to those skilled in the art and may be employed as appropriate.

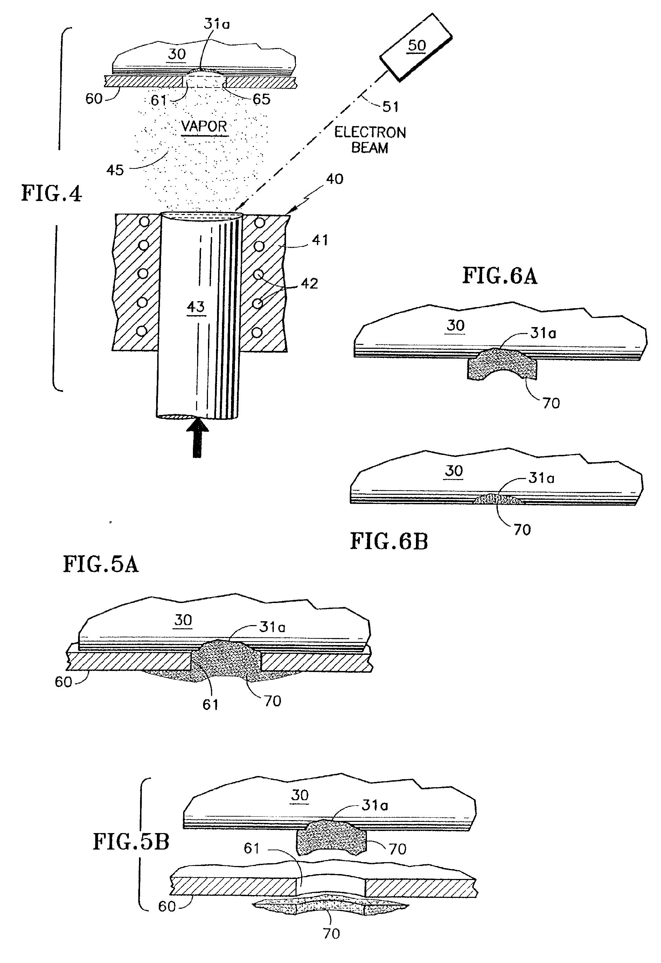

Figure 4 shows a schematic view of the invention process. In Fig. 4, airfoil portion 30 has defect portion 31a. The defect portion 31a has been cleaned to remove all dirt and corrosion products and to expose bare clean substrate metal. A mask 60 is placed over the defect 31a, the mask 60 contains an aperture 61, which is defined by peripheral surface 65, and which preferably generally conforms to the defect so that the mask aperture 61 exposes the defect while the mask 60 masks the undamaged airfoil surface.

The mask may be a rigid, reusable assembly designed to fit a particular superalloy component, or in the alternative, the mask may be disposable.

Rigid masks may be made from heat resistant sheet metal, such as stainless steel or superalloy. Rigid masks are most useful where the damage location is predictable and multiple components are to be repaired.

Disposable masks may be made of flexible ceramic material, such as Fiberfrax, a product of the Unifrax Corporation of Niagara Falls, NY, which is comprised of aluminosilicate fibers formed into paper, felt, or fabric. Such paper, felt or fabric can be cut to form a mask having an aperture and held into place by wires or other mechanical retention means, or ceramic cement (such as braze mask off material).

An effective disposable mask may also be made using a fluid material such as braze stop-off material, such as NicroBraz, Stopyt or Vitta 1AL or 1YT, which are products of the Wall Colmonoy Corporation of Madison Heights, MI, the Wesgo Corporation of San Carlos, CA, and the Vitta Corporation of Bethel, CT, respectively.

The defect 31a is filled or built up with a superalloy repair material deposited by physical vapor deposition. Electron beam physical vapor deposition is an exemplary process.

As illustrated in Fig. 4 in the electron beam physical vapor deposition process, high power electron gun 50 produces a focused electron beam 51 which is directed at melt stock 43 (which is the repair alloy) which is located in crucible 40. Crucible 40 is comprised of crucible 41 which contains water cooling passages 42. Other physical vapor deposition processes such as laser vaporization, cathodic arc deposition and sputtering may also be employed, but electron beam physical vapor deposition is currently the fastest and most economic process.

The superalloy repair alloy will generally be chosen to be similar in composition to the original composition of the component being repaired. However, it is difficult to deposit alloys containing low vapor pressure elements such as Hf, Ta, W, Mo and the like. For this reason, repair alloys which contain minimal amounts of refractory elements may be preferred.

The electron beam physical vapor deposition process is performed under vacuum conditions (typically 10⁻⁵ - 10⁻² Torr). The electron gun produces a high-powered beam, having a power of more than about 5 KW and preferably more than about 10 KW. This high power beam is sufficient to melt the melt stock 43 and to vaporize the melted melt stock to produce a vapor cloud 45. The vapor cloud 45 condenses on the defect 31a, and upon the mask 60. The component is preferably oriented in the vapor cloud so that the defect area faces the vapor source. Vaporization of melt stock and condensation of the vaporized melt stock, which is the superalloy repair material, continues until the defect is filled or built up to at least the original contour of the surface being repaired. The deposited superalloy repair alloy will have a grain size which is less than .05 mm. The repair process involves condensation from the vapor phase directly to the solid phase. There is no liquid phase present, and therefore no solidification with its attendant shrinkage, stresses and cracking which have caused difficulty with the prior repair methods.

Figure 5a illustrates the repaired defect showing the airfoil 30, the defect area 31a and the deposited superalloy repair material 70 which extends through the mask aperture 61, and fills the defect 31a. Figure 5b shows an embodiment in which the mask 60 is spaced away from the defect area 31a so that the buildup of superalloy repair material 70 in the defect area 31a does not entrap the mask 60 or bond the mask 60 to the article being repaired.

Electron beam physical vapor deposition is used to apply metallic and ceramic coatings to gas turbine blades. Such coatings are generally uniform in thickness and cover the entire airfoil surfaces and usually the shroud and platform surfaces. Electron beam physical vapor deposition of protective coatings is performed by holding the component to be coated in the vapor cloud produced by the evaporation of the cathode material by the electron beam. Blades are typically held so that the longitudinal axis of the airfoil is approximately horizontal. In applying uniform thickness protective coatings, the blades are rotated about the longitudinal airfoil axis at a rate of between about 5 and 50 revolutions per minute, most often between about 10 and 30 revolutions per minute. The blade rotation ensures a uniform coating thickness and also minimizes the formation of coating defects known as leaders. In the invention process where only a small portion of the blade is being repaired, it is inefficient to rotate the blade in a continuous fashion around its horizontal axis. However, in order to minimize the formation of defects, it is preferable to oscillate the blade about one or more axes, and preferably about an axis which corresponds essentially to the previously mentioned longitudinal airfoil axis. The component is preferably oscillated about at least one axis through an angle which exceeds the angle occupied by the defect area (the angle which the defect area occupies measured relative to the axis of rotation). Oscillation should be between about 1,800 and 18,000 degrees per minute.

Following the removal of the mask, the repaired article portion will have a contour approximately as shown in Figure 5a where the cleaned damaged area 31a is filled with superalloy repair material 70 to beyond the original surface contour 32 and the built-up superalloy repair material 70 projects from the original surface.

After the masking is removed, the surface contour of the repaired area is restored to the original contour of the repaired area prior to damage. This process is generally referred to as blending and may be performed using any suitable mechanical, chemical, electrochemical and arc discharge technique and combinations thereof. Mechanical techniques include machining and abrasive belt techniques. ECM and EDM techniques may also be employed.

Mechanical treatments may be applied to the repaired area, either before or after blending to enhance the mechanical properties of the repaired area. Processes such as shot peening and laser shock peening may be used to impart residual compressive stresses.

The damaged part will commonly have a protective coating on the undamaged surface adjacent the damaged area. Such coating may comprise a metallic overlay coating, typified by the MCrAIY coatings where M is selected from the group consisting of Fe, Ni, Co, or mixtures of Ni and Co; a diffusion coating such as an aluminide or Pt aluminide coating; or a thermal barrier coating which comprises an insulating ceramic layer which will generally be applied over a bond coat which may be one of the previously described overlay or diffusion coatings.

If such a protective coating is present on the part to be repaired, it may be removed as an initial step in the repair process. Removal may be by chemical means (such as caustic treatments), or by mechanical means (such as machining or grit blasting) or by combinations of these processes.

Coating removal may be complete, removal of the coating from the entire surface of the part, or coating removal may be limited to a local region adjacent the damaged area.

After the damaged area is repaired, a protective coating will be reapplied to the region from which the original coating was removed.

## Claims

1. A method for repairing surface damage (31) to a superalloy article, having a substrate, including the steps of
a) cleaning the surface of the damaged surface to expose undamaged superalloy substrate metal
b) applying a mask (60) to the superalloy component, said mask having an aperture (61) to expose the cleaned damaged area (31) while covering most of the undamaged area of the component
c) using a physical vapor deposition process to apply a layer of superalloy repair material (70) to the masked component, wherein the thickness of the deposited layer equals or exceeds the depth of the cleaned defect (31a)
d) removing the mask (60)
e) removing excess vapor deposited superalloy repair material (70) and contouring the vapor deposited superalloy repair material (70) so that the vapor deposited superalloy repair material (70) substantially replicates the original contour (33) of the turbine component.

2. A method as in claim 1 wherein the physical vapor deposition process is selected from the group which comprises electron beam physical vapor deposition and cathodic arc deposition.

3. A method as in claim 1 or 2 wherein the vapor deposited superalloy repair material (70) is mechanically treated to produce residual compressive stresses.

4. A method as in any preceding claim wherein the undamaged substrate material has an average grain size which is greater than about .1 mm and the vapor deposited superalloy repair material (70) has an average grain size of less than about .05 mm.

5. A method as in any preceding claim wherein the superalloy article has a protective coating, and wherein the protective coating is removed prior to repair, at least adjacent the damage (31), and a replacement protective coating is applied to the area from which the original coating has been removed, following the contouring step.

6. A repaired superalloy article which comprises
a) a superalloy substrate containing a surface damage (31),
b) a fine grained vapor deposited superalloy repair material (70) which fills said surface damage (31).

7. A repaired turbine component which comprises
a) a superalloy substrate containing a surface damage (31),
b) a fine grained vapor deposited superalloy repair material (70) which fills said surface damage (31),
c) said fine grained vapor deposited superalloy repair material (70) having a surface contour which conforms to the surface contour (32) of the adjacent superalloy substrate.

8. A repaired component or article as in claim 6 or 7 wherein the superalloy substrate has an average grain size which exceeds .1 mm and the vapor deposited superalloy repair material (70) has an average grain size which is less than .05 mm.

9. A repaired component or article as in claim 6, 7 or 8 wherein the vapor deposited superalloy repair material (70) is covered by a protective coating selected from the group comprising overlap coatings, diffusion coatings, thermal barrier coatings, and combinations thereof.

10. A superalloy article which is adapted to be repaired which comprises
a) a superalloy article having a surface defect (31a),
b) a mask (60) which covers the majority of superalloy article surface (60), said mask having an aperture (61) which exposes the defect (31a).

11. A superalloy article as in claim 10 wherein the surface defect (31a) has been cleaned.

12. A superalloy article as in claim 10 or 11 which comprises a gas turbine airfoil component (12).

13. A superalloy article as in claim 10, 11 or 12 wherein the mask (60) is formed from a material selected from the group consisting of sheet metal and braze stop-off material and combinations thereof.
